(19) Europäisches Patentamt
European Patent Office
Office européen des brevets

(11) **EP 3 783 277 B1**

(12) **EUROPEAN PATENT SPECIFICATION**

(45) Date of publication and mention
of the grant of the patent:
**30.10.2024 Bulletin 2024/44**

(21) Application number: **18915683.9**

(22) Date of filing: **20.04.2018**

(51) International Patent Classification (IPC):
**F24T 50/00** (2018.01)     **F24T 10/40** (2018.01)
**H10N 10/13** (2023.01)

(52) Cooperative Patent Classification (CPC):
**F24T 10/40; F24T 50/00; H10N 10/13;** Y02E 10/10

(86) International application number:
**PCT/ES2018/070317**

(87) International publication number:
**WO 2019/202180 (24.10.2019 Gazette 2019/43)**

(54) **THERMOELECTRIC GENERATOR WITH NO MOVING PARTS APPLIED TO GEOTHERMAL ENERGY**

THERMOELEKTRISCHER GENERATOR OHNE BEWEGLICHE TEILE ZUR ANWENDUNG AUF GEOTHERMISCHE ENERGIE

GÉNÉRATEUR THERMOÉLECTRIQUE SANS PARTIES MOBILES APPLIQUÉ À LA GÉOTHERMIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**24.02.2021 Bulletin 2021/08**

(73) Proprietor: **Universidad Pública De Navarra**
**31006 Pamplona (ES)**

(72) Inventors:
• **ASTRAIN ULIBARRENA, David**
**31006 PAMPLONA-IRUÑA (ES)**
• **CATALAN ROS, Leyre**
**31006 PAMPLONA-IRUÑA (ES)**
• **ARANGUREN GARACOCHEA, Patricia**
**31006 PAMPLONA-IRUÑA (ES)**
• **ARAIZ VEGA, Miguel**
**31006 PAMPLONA-IRUÑA (ES)**

(74) Representative: **Herrero & Asociados, S.L.**
**Edificio Aqua - Agustín de Foxá, 4-10**
**28036 Madrid (ES)**

(56) References cited:
WO-A1-2017/109589     CN-A- 101 832 673
CN-A- 105 656 353     CN-A- 105 656 353
CN-U- 202 395 697     KR-A- 20090 130 910
KR-A- 20090 130 910     US-A- 4 047 093
US-A- 4 047 093     US-A1- 2010 305 918
US-A1- 2015 292 774

• DATABASE WPI Week 38758, Derwent World Patents Index; AN 2010-A38758, RETRIEVED
• DATABASE WPI Week 36917, Derwent World Patents Index; AN 2016-36917K, XP055647774, RETRIEVED

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The invention relates to the sectors of dry hot rock geothermal energy, and the follow-up and monitoring of volcanic activity. In particular, it relates to a device for converting geothermal energy into usable electrical energy from thermoelectric generators based on the Seebeck effect.

BACKGROUND OF THE INVENTION

The so-called dry hot rock geothermal energy has the most common and abundant geothermal resources. For example, in the United States, they represent 99% of all existing reservoir. However, the electricity generation from them is highly complex, since they do not have either the reservoir or the working fluid necessary for conventional generation based on the Rankine cycle with steam turbines. Therefore, the reservoirs have to be constructed artificially by means of a process consisting of pumping a fluid at high pressure to cause hydraulic fracturing of the hot rock. With the created reservoir, a working fluid is injected cyclically in such a way that it absorbs part of the heat contained in the rocks and proceeds to the electricity generation through the eddying of the vaporized fluid, giving rise to what is known as a enhanced geothermal system. The hydraulic fracturing method has very important drawbacks, such as induced seismicities, which are especially serious in reservoirs linked to recent volcanism. To these drawbacks, it should be added that the pieces of equipment used in Rankine cycles, such as turbines, pumps, cooling towers, etc., are complex, expensive and costly to maintain and operate. This series of technical problems causes many geothermal reservoirs of dry hot rock that, despite the high temperatures they have, are not currently in operation

Compared to technology based on the Rankine cycle with steam turbines, systems based on the extraction of heat from the subsoil by means of "heat pipes" have also been described. Many of them are intended to take advantage of the heat obtained for heating purposes, without any relation to the generation of electricity through thermoelectric modules; therefore they refer to a technical problem different from the present invention. This is the case of the patent documents or utility models WO201481911A2, CN206637706U, CN201145446Y and CN101832673B. Some documents have also been identified that describe the extraction of heat by means of "heat pipes" that in their condensing part yield heat to thermoelectric modules, such as the Korean patent KR20090130910A, which uses "heat pipes" covered with insulating material, or the Chinese application CN105656353A, which also uses a heat pipe covered with a thermal insulating layer.

Technical differences are observed between the aforementioned KR20090130910 and the present proposal: in the former, a single thermoelectric module is used coupled to the heat pipe, and the final dissipation of heat from the cold side of the thermoelectric module is achieved by means of vanes or radiators, while in the present invention there are at least two thermoelectric modules that in turn dissipate heat from their cold side by means of their respective phase change thermosyphons.

The application CN105656353A describes the application of the electricity obtained to the generation of light and gives importance to the transmission of heat over a long distance, including in its "heat pipe" intermediate heat exchange modules, unnecessary in the present invention.

Thermosyphons and heat pipes are passive devices that work by using the latent heat of an internal fluid, called the working fluid, to transfer large amounts of heat with minimal temperature differences. These high thermal conductance heat exchangers are divided into three sections: evaporator, adiabatic section, and condenser. The operation of these devices begins with a flow of heat applied to the evaporator, causing the vaporization of the working fluid. The steam circulates through the adiabatic region to the condenser, where it condenses, yielding its phase change heat and returns to the evaporator to absorb a heat flow again, thus achieving continuous operation. It is in the return of the liquid that thermosyphons clearly differ from heat pipes ("Heat pipes: theory, design and applications", David Reay, Ryan McGlen, Peter Kew, 2014). Heat pipes necessarily have a porous material in their interior that uses capillarity to move the liquid from the condenser to the evaporator. In the case of thermosyphons, the return of condensates is carried out by the effect of gravity, and therefore the evaporator must necessarily be placed in the lower part of the device.

A unique feature of this type of exchangers is that the evaporator can be located at a great distance from the condenser, suffering a minimum temperature difference. That is why heat pipes have been used to transport geothermal heat from several meters deep to the surface. However, since it is necessary to use a porous material inside them, heat pipes are difficult and expensive to manufacture, in addition to having a higher thermal resistance due to said porous material.

In practically all the volcanoes existing in the world, monitoring is carried out both by satellite and terrestrial by means of remote stations equipped with probes for the detection of seismic movements, gas analysis and heat flow measurements. The data recorded by these probes are sent by radio probes to a data processing center where they are processed.

This system for the detection and recording of variables of which the remote volcanic surveillance stations consist, needs a supply of energy to be able to function, which electrically feeds both the probes and the signal emission system. This energy consumption varies depending on the number of probes and their data emission frequency, but it can be estimated at between 1 and 5 Wh/day.

Logically, the vast majority of volcanic monitoring stations are located in areas that are difficult to access and with no possibility of connection to the electricity grid, so they need an autonomous energy supply system. In some of the sites where these stations are located, the installation of a photovoltaic panel performs this function of supplying energy. However, with this system, the presence of a battery is necessary which, depending on the weather and the presence of volcanic ash, can be very large. In addition, there are many locations of the volcanic monitoring stations, which due to their altitude record harsh winters with a long period of time with significant snowfalls, which disable the operation of photovoltaic panels. In these cases, important batteries are necessary that must be changed from time to time, usually by helicopter. Or the loss of data broadcast during winter periods.

Therefore, there is a technological problem derived from the loss of data emission in winter periods and the need to use batteries, which must periodically be changed, with the difficulty and cost that this entails.

SUMMARY OF THE INVENTION

The object of the present invention is to provide a thermoelectric generator applied to geothermal energy that solves the technical problems described in the previous section. To this end, the device object of the invention is based on Seebeck effect thermoelectric generators associated with thermosyphon type heat exchangers and phase change. This considerably reduces their maintenance needs and lengthens their useful life, since they do not contain moving parts, in addition to involving a reduced environmental impact and good integration with the environment, due to their small size and the lack of rock fracture. Compared to devices that incorporate heat pipes, they are less expensive and have better thermal conductance, since the conduction resistance of the porous material is eliminated. This fact allows that, by transporting the heat from the hot spot (deep in the ground) to the thermoelectric generator device, the temperature difference between both sources is less, increasing the performance of the electrical generation. Heat pipes also have limitations in the heat power to dissipate, due to the porous material. Therefore, the advantages of using thermosyphons with respect to "heat pipes" are their greater simplicity and lower manufacturing cost, and their better efficiency in transmitting heat through the wall, which represents an advantage for the intended purpose in the present invention. On the other hand, the limitation of the phase change thermosyphons with respect to the heat pipes is that their position shall necessarily place the evaporator in the lower part and the condenser in the upper part, so that the return of the condensed fluid is produced by action of gravity. However, this limitation does not prevent the intended uses for the generation of electricity from hot rock, which, logically, tends to be in a lower position than the atmosphere where the dissipation of heat from the device ends. Likewise, it is a fully scalable technology, which greatly facilitates the installation and application of the invention both at low and high power. The invention has an especially practical application in volcanic monitoring stations. Thus, the invention proposes a thermoelectric generator applied to geothermal energy comprising a two-phase thermosyphon called the hot side, intended to be introduced downward into the rock, at least two thermoelectric modules in contact with the part of the thermosyphon condenser on the hot side and at least two two-phase thermosyphons respectively located on the cold side of each thermoelectric module to dissipate unusable heat power. The cold side thermosyphons, on each side of the thermoelectric modules, can have different sizes or be made up of a variable number of tubes. Optionally they are provided with vanes to improve dissipation.

BRIEF DESCRIPTION OF THE FIGURES

In order to help a better understanding of the features of the invention and to complement this description, the following figures are attached as an integral part thereof, the nature of which is illustrative and not limiting:

Figure 1 shows the principle of operation of the invention, consisting of two-phase thermosyphon on both sides of the thermoelectric modules.
Figure 2 shows in greater detail a possible design of the proposed invention.
Figure 3 shows the low thermal resistances that are achieved with the invention.
Figure 4 represents a graph of power production with a system according to the invention.

DETAILED DESCRIPTION

The device of the invention comprises a two-phase thermosyphon, whose lower part or evaporator is intended to be introduced into the rock (and which from now on will be called the hot side thermosyphon), at least two thermoelectric modules in contact with the previous thermosyphon in its upper part or condenser and at least two two-phase thermosyphon type heat exchangers on the cold side of the thermoelectric modules to dissipate the unusable heat power, and thus ensure the temperature difference between the two sides of each thermoelectric module, on which electricity generation depends. Thermoelectric modules transform heat from the condenser side into electricity by virtue of to the Seebeck effect. This effect describes the appearance of an electromotive force in a circuit formed by two conductors of different material joined at their ends when these joints are kept at different temperatures. This force depends on the Seebeck coefficient of each of the materials and on the difference in temperature between the two conductors.

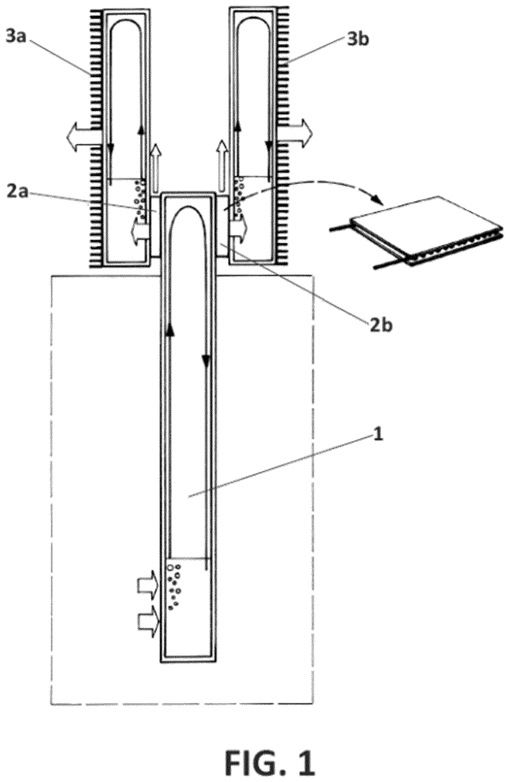

The operation of the device can be seen in Figure 1 wherein, in a particular implementation, the thermoelectric modules 2a and 2b and the cold side thermosyphons 3a and 3b are arranged symmetrically around the hot side thermosyphon condenser 1. This thermosyphon will be in contact with the hot spot in the ground, at a certain depth, to absorb heat from it and transmit it to the thermoelectric modules that are located above the surface of the ground, which convert part of this heat flow into electric power. The rest of the unconverted heat is evacuated to the environment through two-phase thermosyphons placed between the cold side of the thermoelectric modules and the outside air. The working fluid is preferably water.

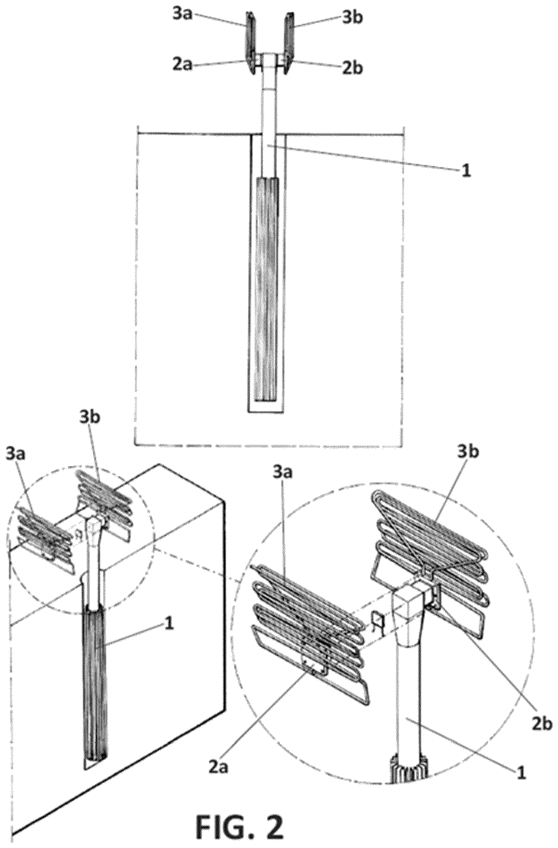

The particular case presented in Figure 1 shows a particular implementation, in which there is a two-phase thermosyphon 1 made up of a single tube on the hot side. In the condenser part of this thermosyphon, two thermoelectric modules 2a and 2b have been placed to transform the heat coming from the rocks into electric power. To dissipate the energy that has not been transformed into electricity, there is a two-phase thermosyphon (called the cold side) for each module. The number of thermoelectric modules is variable depending on the diameter of the hot side thermosyphon, but there are at least two. The diameter and length of the hot side thermosyphon will depend on the particular reservoir. The phase change thermosyphons that extract heat from the cold side of the thermoelectric modules can be provided with vanes to increase the exchange area with the environment so that said dissipation is produced by natural convection. They can also be made up of more than one tube (figure 2).

All in all, there is a robust thermoelectric generator, without moving parts or auxiliary consumption, fully scalable and with a minimal environmental impact due to its small size and to the fact that hydraulic fracturing of the rock is not necessary.

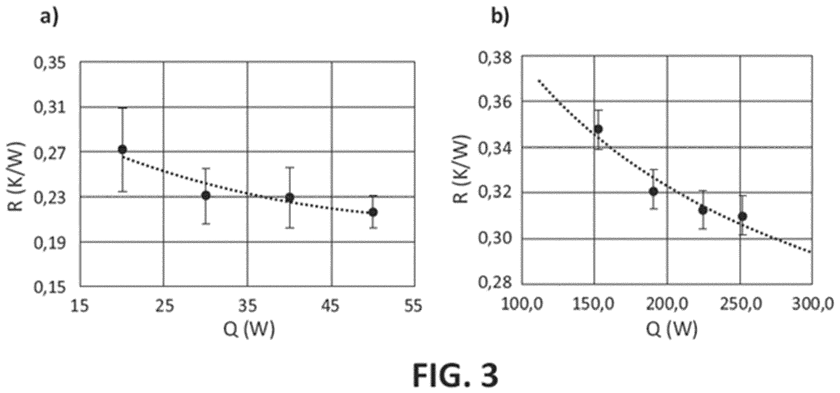

Figure 3 shows the experimental results obtained with the two types of thermosyphons that make up the present invention: a) cold side thermosyphon e, b) hot side thermosyphon. The parameter shown in the figure and that represents the thermal behavior of the devices is the thermal resistance R whose expression is given by:

$$R = \frac{\Delta T}{\dot{Q}}$$

Wherein: $\Delta T$ is the temperature jump between spots. Difference between the temperature of the hot rock and the hot side of the thermoelectric module, in the case of the hot side thermosyphon; and difference between the cold side of the thermoelectric module and the environment for the case of the cold side thermosyphon, $\dot{Q}$ the heat flux that is absorbed from the hot rock in the case of the hot side thermosyphon and the heat flux that it expels to the atmosphere in the case of the cold side thermosyphon.

In short, this parameter is basically the inverse of the thermal conductance and indicates the resistance that this device offers to the flow of heat. Thus, low thermal resistance means that the device is capable of transmitting heat with little drop in temperature between the spots. Specifically, the cold side thermosyphon developed in this invention offers values lower than 0.23 K / W, which means that to transport 50W of heat, the temperature drop will be only 11.5K.

Likewise, the hot side thermosyphon offers very good thermal resistance values, lower than 0.32 K / W, which indicates that by transporting 200W of heat from the hot rock to the thermoelectric module, the temperature drop will be 64K.

These low thermal resistance values obtained in this invention ensure a greater temperature jump between the sides of the thermoelectric modules, since the temperature of the hot side of the module will be close to that of the hot rock and that of the cold side close to that of the environment, which provides high yields for converting thermal to electric power, with the particularity of doing so without any moving parts and without using porous material.

It should be noted that both the thermal resistance of the hot and cold thermosyphons improve when the exchanged heat power increases, mainly due to the convection coefficients in phase change and in natural convection.

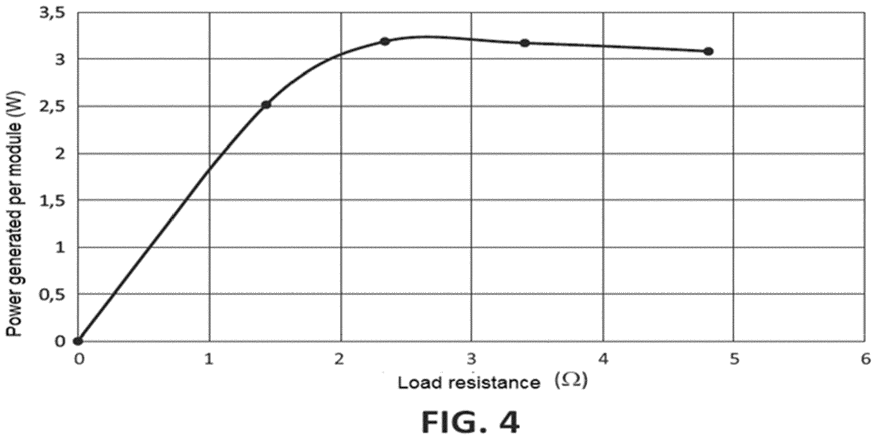

Regarding electricity generation, 3.2 net electrical W has been generated for each 40x40mm thermoelectric module, for a hot spot temperature of 200°C, as can be seen in figure 4. That is to say, for this implementation that has two thermoelectric modules, the net electricity generation has been 6.4W.

The invention has a special practical application in volcanic monitoring stations.

The thermoelectric generators that are proposed in this patent can take advantage of the heat emission of these volcanic areas (usually in the form of fumaroles or directly in the form of hot rock) to continuously supply electric power to the volcanic monitoring stations, thus solving the aforementioned technological problem and improving its operation even in adverse weather conditions since the available temperature jump is maximized.

In view of this description and figure, the person skilled in the art will understand that the invention has been described according to some preferred embodiments thereof, but that multiple variations can be introduced in said preferred embodiments, without exceeding the object of the invention as it has been claimed.

## Claims

1. Thermoelectric generator applied to geothermal energy comprising a

   two-phase thermosyphon (1) called the hot side, the lower part of which is intended to be introduced into the hot subsoil, at least two thermoelectric modules (2a,2b) in contact with the upper part of the thermosyphon (1) on the hot side placed in contact with the atmosphere, **characterised in that** the thermoelectric generator further comprises at least two two-phase thermosyphons (3a,3b) respectively located on the cold side of each thermoelectric module (2a, 2b) to dissipate the unusable heat power and ensure the temperature difference between the two sides of each thermoelectric module (2a, 2b).

2. Thermoelectric generator applied to geothermal energy according to claim 1, **characterized in that** the thermoelectric modules (2a,2b), in number of two or more, are arranged in symmetrical positions with respect to the longitudinal axis of the hot thermosyphon (1).

3. Thermoelectric generator applied to geothermal energy according to claims 1 or 2 **characterized in that** the working fluid of the two-phase thermosyphons is water.

4. Thermoelectric generator according to any of the preceding claims, **characterized in that** the two-phase thermosyphons (3a,3b) on the cold side are vaned.

5. Thermoelectric generator according to any of the preceding claims, **characterized in that** the two-phase thermosyphons (3a,3b) comprise a plurality of tubes.

6. Use of a thermoelectric generator according to any of the preceding claims as an on-site electric power supply system in volcanic surveillance and monitoring stations.

## Patentansprüche

1. Thermoelektrischer Generator, der auf geothermische Energie angewendet wird, mit

   einem Zweiphasen-Thermosiphon (1), der die heiße Seite genannt ist und dessen unterer Teil vorgesehen ist, in den heißen Untergrund eingebracht zu werden,
   mindestens zwei thermoelektrischen Modulen (2a, 2b), die mit dem oberen Teil des Thermosiphons (1) auf der heißen Seite in Berührung sind, der in Berührung mit der Umgebung platziert ist,
   **dadurch gekennzeichnet, dass** der thermoelektrische Generator außerdem umfasst mindestens zwei Zweiphasen-Thermosiphons (3a, 3b), die jeweils auf der kalten Seite jedes thermoelektrischen Moduls (2a, 2b) angeordnet sind, um die nicht nutzbare Wärmeleistung abzuleiten und die Temperaturdifferenz zwischen den beiden Seiten jedes thermoelektrischen Moduls (2a, 2b) sicherzustellen.

2. Thermoelektrischer Generator, der auf geothermische Energie angewendet wird, gemäß Anspruch 1, **dadurch gekennzeichnet, dass** die thermoelektrischen Module (2a, 2b), in einer Anzahl von zwei oder mehr, in symmetrischen Positionen mit Bezug auf die Längsachse des heißen Thermosiphons (1) angeordnet sind.

3. Thermoelektrischer Generator, der auf geothermische Energie angewendet wird, gemäß den Ansprüchen 1 oder 2, **dadurch gekennzeichnet, dass** das Arbeitsfluid der Zweiphasen-Thermosiphons Wasser ist.

4. Thermoelektrischer Generator gemäß einem der vorstehenden Ansprüche, **dadurch gekennzeichnet, dass** die Zweiphasen-Thermosiphons (3a, 3b) auf der kalten Seite mit Schaufeln versehen sind.

5. Thermoelektrischer Generator gemäß einem der vorstehenden Ansprüche, **dadurch gekennzeichnet, dass** die Zweiphasen-Thermosiphons (3a, 3b) eine Vielzahl von Rohren haben.

6. Verwendung eines thermoelektrischen Generators gemäß einem der vorhergehenden Ansprüche als ein Stromversorgungssystem vor Ort in Vulkanüberwachungs- und -beobachtungsstationen.

## Revendications

1. Générateur thermoélectrique appliqué à la géothermie comprenant un thermosiphon (1) diphasique appelé le côté chaud, dont la partie inférieure est destinée à être introduite dans le sous-sol chaud, au moins deux modules thermoélectriques (2a, 2b) en contact avec la partie supérieure du thermosiphon (1) sur le côté chaud placée en contact avec l'atmosphère,
   **caractérisé en ce que** le générateur thermoélectrique comprend en outre au moins deux thermosiphons diphasiques (3a, 3b) situés respectivement sur le côté froid de chaque module thermoélectrique (2a, 2b) pour dissiper la puissance thermique inutilisable et assurer la différence de température entre les deux côtés de chaque module thermoélectrique (2a, 2b).

2. Générateur thermoélectrique appliqué à la géothermie selon la revendication 1, **caractérisé en ce que** les modules thermoélectriques (2a, 2b), au nombre de deux ou plus, sont agencés en positions symétriques par rapport à l'axe longitudinal du thermosiphon (1) chaud .

3. Générateur thermoélectrique appliqué à la géothermie selon les revendications 1 ou 2, **caractérisé en ce que** le fluide de travail des thermosiphons diphasiques est de l'eau.

4. Générateur thermoélectrique selon l'une quelconque des revendications précédentes, **caractérisé en ce que** les thermosiphons diphasiques (3a, 3b) sur le côté froid sont à ailettes.

5. Générateur thermoélectrique selon l'une quelconque des revendications précédentes, **caractérisé en ce que** les thermosiphons diphasiques (3a, 3b) comprennent une pluralité de tubes.

6. Utilisation d'un générateur thermoélectrique selon l'une quelconque des revendications précédentes comme système d'alimentation électrique sur site dans des stations de surveillance et de contrôle des volcans.

3a

3b

2a

2b

1

FIG. 1

3a    3b
2a    2b
1

3b
3a
1

3a
3b

2b
1

2a

**FIG. 2**

**FIG. 3**

EP 3 783 277 B1

FIG. 4

Load resistance ($\Omega$)

Power generated per module (W)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 201481911 A2
- CN 206637706 U
- CN 201145446 Y
- CN 101832673 B

- KR 20090130910 A
- CN 105656353 A
- KR 20090130910

**Non-patent literature cited in the description**

- **DAVID REAY ; RYAN MCGLEN ; PETER KEW.** *Heat pipes: theory, design and applications,* 2014